Europäisches Patentamt

**European Patent Office**

**Office européen des brevets**

(11) Publication number: **0 145 415**

**B1**

(12) **EUROPEAN PATENT SPECIFICATION**

(45) Date of publication of patent specification: **25.04.90**

(21) Application number: **84308284.3**

(22) Date of filing: **29.11.84**

(51) Int. Cl.⁵: **H 01 L 21/74,** H 01 L 21/86, H 01 L 21/76

(54) Process for fabricating a soi type semiconductor device.

(30) Priority: **30.11.83 JP 225653/83**

(43) Date of publication of application: **19.06.85 Bulletin 85/25**

(45) Publication of the grant of the patent: **25.04.90 Bulletin 90/17**

(84) Designated Contracting States: **DE FR GB**

(56) References cited:
**IBM TECHNICAL DISCLOSURE BULLETIN, vol. 24, no. 11A, April 1982, pages 5458-5459; Armonk N.Y., US M.D.HULVEY et al: "Dielectric isolation process"**
**RCA REVIEW, vol. 44, no. 2, June 1983, pages 250-269; Princeton, N.J. US L. JASTRZEBSKI: "Comparison of different SOI technologies: Assets and liabilities"**
**JOURNAL OF THE ELECTROCHEMICAL SOC. vol.130, no 11, November 1983, pages 2271-2274; Manchester N.H. US K.TAKEBAYASHI et al.: "Infrared radiation annealing of ion-implanted polycrystalline silicon using a graphite heater"**

(73) Proprietor: **FUJITSU LIMITED 1015, Kamikodanaka Nakahara-ku Kawasaki-shi Kanagawa 211 (JP)**

(72) Inventor: **Takaoka, Matsuo c/o FUJITSU LIMITED Patent Department 1015 Kamikodanaka Nakahara-ku Kawasaki-shi Kanagawa 211 (JP)**
Inventor: **Sasaki, Nobuo c/o FUJITSU LIMITED Patent Department 1015 Kamikodanaka Nakahara-ku Kawasaki-shi Kanagawa 211 (JP)**
Inventor: **Kawamura, Seiichiro c/o FUJITSU LIMITED Patent Department 1015 Kamikodanaka Nakahara-ku Kawasaki-shi Kanagawa 211 (JP)**
Inventor: **Hataishi, Osamu c/o FUJITSU LIMITED Patent Department 1015 Kamikodanaka Nakahara-ku Kawasaki-shi Kanagawa 211 (JP)**

(74) Representative: **Sunderland, James Harry et al HASELTINE LAKE & CO Hazlitt House 28 Southampton Buildings Chancery Lane London WC2A 1AT (GB)**

Courier Press, Leamington Spa, England.

(56) References cited:

PATENT ABSTRACTS OF JAPAN, vol. 6, no. 37, (E-97)(915), March 6, 1982 & JP-A-56 157 038 (FUJITSU) 04-12-1981

APPLIED PHYSICS LETTERS, vol. 40, no. 5, March 1, 1982, pages 394, 395; Am. Inst. of Physics, New York, US S.KAWAMURA et al.: "Recrystallisation of Si on amorphous substrates by doughnut-shaped CW Ar laser beam"

PATENT ABSTRACTS OF JAPAN, vol. 6, no. 254, (E-148)(1132), Decemebr 14, 1982 & JP-A-57 154 871 (TOKYO SHIBAURA DENKI K.K.) 24-09-1982

JOURNAL OF THE ELECTROCHEMICAL SOC. vol. 130, no. 1, January 1983, pages 199-202; Manchester, N.J., US S. WU: "Laser diffusion in silicon from spin-on arsenic glass."

## Description

The present invention concerns a process for fabricating a SOI (Semiconductor On Insulator) type semiconductor device.

SOI type semiconductor devices or dielectric isolated integrated circuits (ICs), in which circuit elements such as transistors and diodes are isolated from each other by insulating material, are increasingly in demand, due to their merits of low stray capacitance and high breakdown voltage. The substrate used for fabricating such a device has a structure in which single crystal semiconductor regions surrounded around their peripheries and bottoms by insulating material are embedded in the substrate like islands. Recently a technique for recrystallizing poly-crystalline silicon (poly-silicon) by irradiation with an energy beam such as a laser beam has been developed and is beginning to be applied in the fabrication of SOI type devices. Further details of this technique are disclosed in, for example, Appl. Phys. Lett. 40(5), 1 March 1982: "Recrystallization of Si on amorphous substrates by doughnut-shaped cw Ar laser beam" by S. Kawamura et al. IEEE ED Letters, vol. EDL-4, No. 10, Oct. 1983: "Three-Dimensional CMOS IC's Fabricated by Using Beam Recrystallization" by S. Kawamura, N. Sasaki et al.

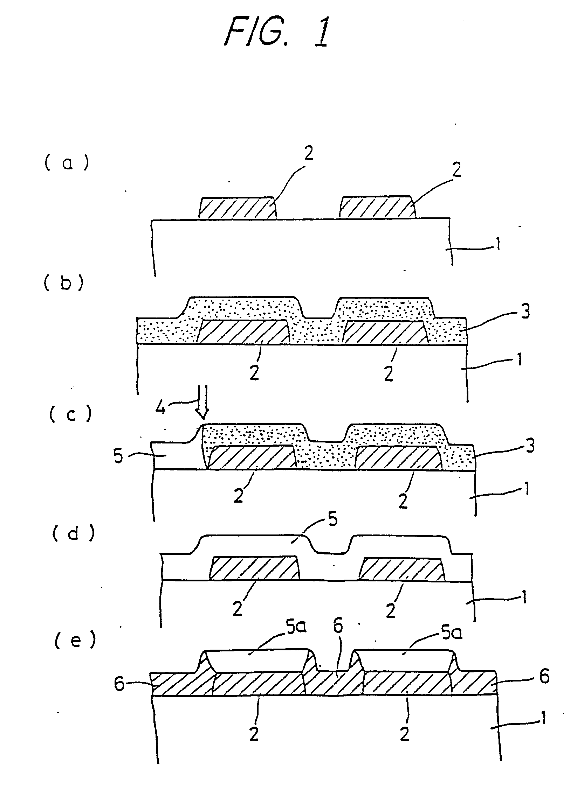

In order that the improvements and simplifications which can be afforded by the present invention may be clearly understood, and that the advantages of the present invention may be clear, a previous process for preparing such an insulated substrate will be described with reference to Fig. 1.

Fig. 1 shows schematically, in partial cross sectional views (a) to (e), fabrication of a substrate. On a silicon substrate 1 a silicon dioxide ($SiO_2$) film 0.5 μm thick is grown and patterned as shown in Fig. 1(a). The size and position of each pattern 2 are generally equal to the size and position of an isolated region to be grown later. The patterns 2 are patterned by conventional photo-lithographic and etching processes.

Next, over the entire surface of the substrate a poly-silicon layer 3 is grown. The thickness of the layer is 0.8 to 1.0 μm (Fig. 1(b)).

Next, as shown in Fig. 1(c), the surface of the substrate is irradiated by a laser beam 4. The irradiation is effected first at a point at which a pattern 2 does not exist, then poly-silicon under the laser beam spot is melted and recrystallized forming single crystal silicon having a similar crystal orientation to that of the substrate 1.

As the laser beam 4 is moved gradually to the right in Figure 1(c), the single crystal silicon grows to the right as the beam is shifted. Finally the poly-silicon layer 3 covering the entire surface of the substrate is converted to a single crystal silicon layer 5 as shown in Fig. 1(d). Such growth of single crystal material is called lateral epitaxial growth, and is disclosed in, for example, ECS Meeting Montreal, Canada, May (1982) "Laser-Induced Lateral Epitaxial Growth of Si over $SiO_2$" by S. Kawamura et al.

Next, a portion of layer 5 over a pattern 2 is coated with a protection film (not shown), for example of silicon nitride ($Si_3N_4$), and the substrate is oxidized. Then, as shown in Fig. 1(e), the silicon layer 5 where uncovered by the protection film is converted into $SiO_2$ film 6, and an island like silicon single crystal region 5a is formed which is surrounded by $SiO_2$.

The substrate prepared in the manner described above is used for fabricating various types of devices such as complementary high voltage devices and affords its own advantages.

However, for some applications, such as bipolar devices, a substrate is required to be provided with a buried layer as in ordinary bipolar devices.

Further, in some cases, for example for high voltage applications, imperfect crystallisation occurring at a boundary portion of a single crystal region 5a has an adverse effect.

Improvement or expansion of the previous process (for example, U.S. Pat. Appl. Serial No. 640,719, Apr. 27, 1984 by R. Mukai et al.) is required to overcome such problems.

According to the present inventions as defined in claim 1, claim 6 or claim 8, there is provided a process for forming a semiconductor on insulator (SOI) type semiconductor device.

Embodiments of the present invention provide processes for fabricating monocrystalline semiconductor (e.g. silicon) islands embedded in a substrate of insulator using a technique of recrystallization of poly-crystalline semiconductor (silicon) by means of an energy beam. Embodiments of the present invention can provide for simplification with regard to the preparation of a substrate used for an SOI structured device.

Embodiments of the present invention can provide improvement or expansion of processes for fabricating SOI type semiconductor devices.

An embodiment of the present invention can provide a process for preparing a SOI substrate (substrate which has isolated single crystal regions embedded in insulator, and is used for an SOI type device) which is provided with a buried layer.

An embodiment of the present invention can provide a process for preparing a SOI substrate in which an isolated single crystal region is properly doped for the fabrication of a device in the isolated region.

An embodiment of the present invention can provide a process for preparing a SOI substrate which substrate is unaffected by imperfect crystallization occurring at the boundary of an isolated single crystal region.

In a process embodying the present invention a poly-crystalline material is covered with a "cap", and furthermore the cap is doped with a suitable dopant. This dopant is diffused into single crystal material at the same time as the single crystal material is grown from the polycrystalline material by irradiation with a laser beam.

Embodiments of the present invention can be modified or extended in various ways as convenient to fabricate various types of device within the scope of the invention. Several methods of fabricating bipolar transistors utilizing embodiments of the present invention are described below.

In a process embodying the present invention provision can be made to avoid crystal imperfection which can arise at the border of a single crystal region. One case involves opening a window exposing part of the single crystal region, but not the border of the region, so that the center part of the region is used. Another case involves covering the side walls of the single crystal region with a high quality silicon dioxide film. To do so, an $SiO_2$ layer surrounding the single crystal region is first removed, and the exposed side walls of the single crystal region are oxidized, and then an $SiO_2$ layer is regrown.

Reference is made, by way of example, to the accompanying drawings, in which:

Fig. 1 shows schematically, in a series of partial cross sectional views, the fabrication of an SOI substrate by a previous process,

Fig. 2 illustrates, in a series of partial cross sectional views, a process embodying the present invention for fabricating a SOI substrate, wherein a buried layer is formed in an isolated single crystal region,

Fig. 3 illustrates, in a series of partial cross sectional views, a modification of the process explained with reference to Fig. 2, which modified process starts with poly-silicon material embedded in an $SiO_2$ layer,

Fig. 4 illustrates a further modification of the process of Fig. 2, wherein an isolated single crystal region is doped in a predetermined pattern,

Fig. 5 illustrates another process embodying the present invention for fabricating an isolated single crystal region having a buried layer,

Fig. 6 illustrates another process embodying the present invention, in which the effects of crystal imperfection occurring at boundaries of a single crystal region are avoided by the use of a window which avoids peripheral parts of the single crystal region, and

Fig. 7 illustrates another process embodying the present invention in which the effects of the crystal imperfection occurring at boundaries of a single crystal region are avoided, in which process an $SiO_2$ layer around a single crystal region is first removed, side edges of the single crystal region are oxidized in clean ambient and a new $SiO_2$ layer is regrown.

The present invention will be described with reference to examples of embodiments of the present invention.

First example

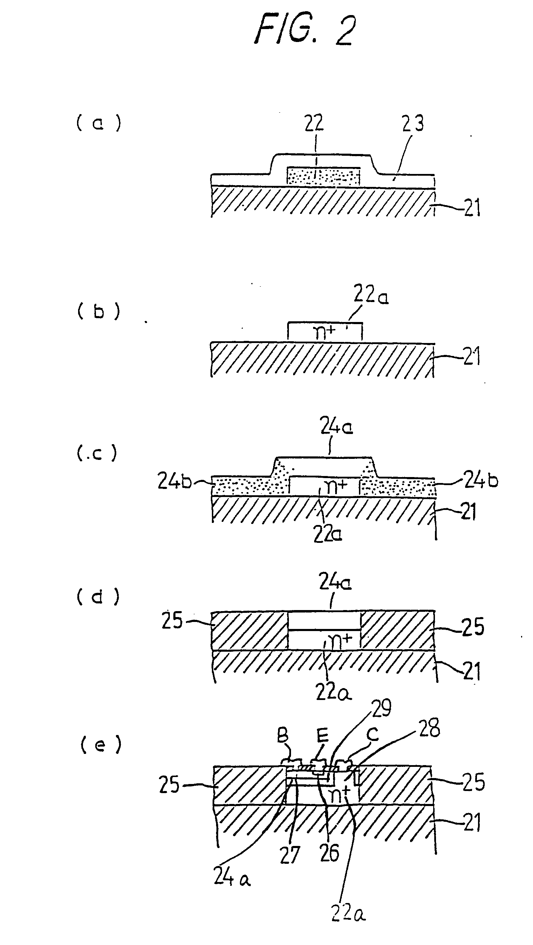

Fig. 2 illustrates an example of a process embodying the present invention for fabricating a substrate for use for a SOI type semiconductor device (a SOI substrate). The process starts with a step for growing a poly-silicon layer 22 approximately 1 µm thick on an insulator layer 21. The insulator layer 21 may be a silicon dioxide layer grown on a silicon substrate (not shown), or it may be provided by a sapphire substrate for example. The poly-silicon layer 22 is patterned according to the shape and size of a device to be fabricated in the substrate, as shown in Fig. 2(a). Then the entire surface of the substrate (the insulator layer 21 and poly-silicon layer 22) is coated with an insulator film 23 approximately 1 µm thick. This insulator film 23 is preferably transparent and desirably for an embodiment of the present invention contains a dopant of a desired conductivity type. Phospho-silicate glass (PSG) is for example used for film 23 when n-type dopant phosphorous is required. The processes used for growing the layers 21, 22 and film 23 and for patterning may all be conventional semiconductor device manufacturing processes, for example, oxidation, chemical vapour deposition (CVD) and photo-lithographic etching.

The insulator film 23 is called a "cap". When laser beam irradiation is effected through the cap, laser beam reflection is decreased and beam (utilisation) efficiency is increased. Moreover, the cap serves as an insulation jacket for crystal protection and prevents uneven crystallization and provides a flat recrystallized surface. More detail of the laser crystallization using a cap is described in, for example, Appl. Phys. Lett. 40(5), 1. March 1982: "Recrystallization of Si on amorphous substrates by doughnut-shaped cw Ar laser beam" by S. Kawamura et al.

In the present embodiment of this invention, a laser beam of approximately 10 watts continuous beam energy is irradiated onto the poly-silicon layer 22, through the PSG film 23. The poly-silicon layer 22 is annealed by the laser beam and is converted to a single crystal layer 22a. At the same time the recrystallized silicon layer 22a is doped with phosphorus and becomes a highly doped $n^+$-type single crystal region. Fig. 2(b) shows a stage after the PSG layer 23 has been washed out. In this embodiment of the present invention the silicon layer 22a (this layer is called the first single crystal layer hereinafter) will eventually form a buried layer.

For this purpose, a silicon layer approximately 3 µm thick is epitaxially grown over the entire surface of the substrate (first single crystal layer 22a and insulating layer 21). The thickness to which the epitaxial layer is grown depends upon the device eventually to be fabricated in the recrystallized and epitaxially grown silicon layers; for instance if a bipolar device is to be fabricated the thickness is comparatively large, whilst if a MOS type device is to be fabricated the thickness may be comparatively small. By this epitaxial growing process, a single crystal layer region 24a is grown over the single crystal layer region 22a (this layer region 24a is called the second single crystal layer hereinafter), but over the $SiO_2$ layer 21 single crystal growth does not occur and a poly-crystalline silicon (poly-silicon) layer region 24b grows, as shown in Fig. 2(c). Such epitaxial growing process is known in the art, so details of the process will not be described herein, for the sake of simplicity.

Next, as shown in Fig. 2(d), the poly-silicon layer region 24b is etched off, and a new insulation layer 25 is regrown in its place. The insulation layer 25 may be a SiO₂ layer, and can be grown by a chemical vapour deposition (CVD) method for example. Surface polishing is then effected to show (expose) the silicon layer (region 24a). Thus, a silicon layer having a highly doped buried layer beneath thereof and surrounded by an insulator is fabricated.

Finally, in a case in which a bipolar circuit element is to be formed, an emitter region 26, a base region 27, and a collector contact region 28 are formed in the second single crystal layer region 24a as shown in Fig. 2(e). The second single crystal region 24a is utilised as the collector region. In Fig. 2(e) the symbols E, B and C designate an emitter electrode, a base electrode and a collector electrode respectively, and 29 designates an SiO₂ film for surface protection. The electrodes and the surface protection film can be fabricated by conventional methods, and thus a dielectric isolated transistor is formed.

The material used for the cap (23) is not limited to PSG; other insulator layer materials such as antimonic-silicate glass (SbSG) may be used. Circuit elements other than bipolar transistors can be fabricated in the isolated epitaxial region 24a. Other devices such as diodes, MOS transistors or any other types of device can be fabricated by appropriate methods.

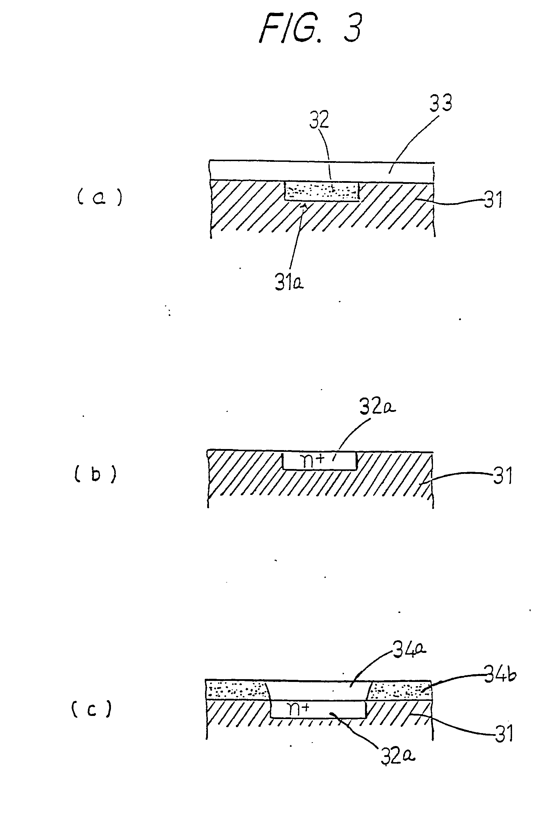

Modifications of the above described processes are possible for embodiments of the present invention, for various applications. For example in the embodiment illustrated with reference to Fig. 2, the process commences with a poly-silicon layer 22 patterned on an insulator layer 21, but it can be modified to commence with a poly-silicon layer region embedded in an insulator layer as shown in Fig. 3. In Fig. 3(a) a poly-silicon layer region 32 is formed in a depression 31a engraved in a SiO₂ layer 31. After this stage the process is very similar to that of Fig. 2. Namely, a PSG layer 33 is coated over the entire surface of the substrate, and by laser recrystallization the poly-silicon layer region 32 is crystallized to form a highly doped (n⁺-type) first single crystal layer region 32a (Fig. 3(b)). Next, over the entire surface of the substrate a silicon layer is grown epitaxially. By this expitaxial growth, a second single crystal layer region 34a is grown over the first single crystal layer region 32a, but over the remaining surface of poly-silicon layer region 34b is grown, as shown in Fig. 3(c). Such epitaxial growth is called a selective epitaxial growth and is used in semiconductor production. When the poly-silicon layer region 34b is removed, and an SiO₂ layer is regrown in its place, the substrate becomes equivalent to that of Fig. 2(d). The poly-silicon layer 34b may be oxidized and the substrate of Fig. 2(d) can be obtained. Subsequent process steps can be the same as those employed in relation to the embodiment of Fig. 2.

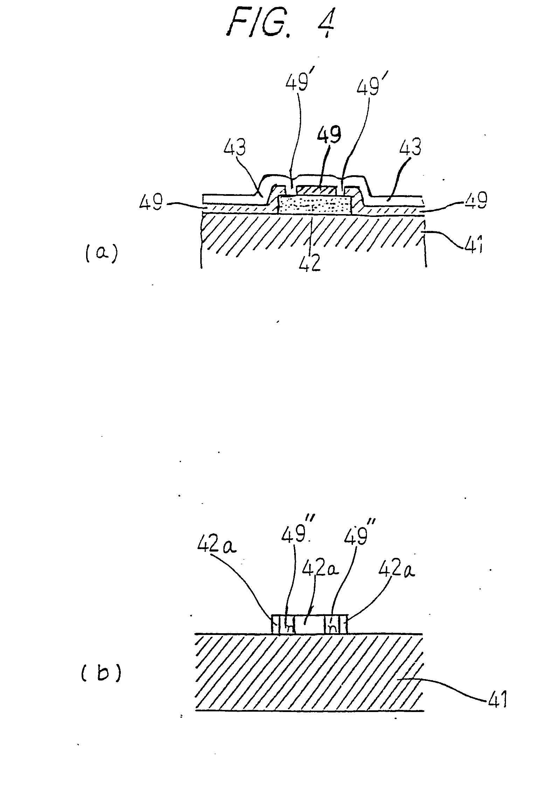

Another modified embodiment of the present invention is shown in Fig. 4. In this case a recrystallized single-crystal silicon layer region (corresponding to layer region 22a in Fig. 2) is doped with appropriate doping profile in accordance with a predetermined pattern. In Fig. 4, 41 is an insulating layer and 42 is a poly-silicon region. As shown, before coating the poly-silicon region 42 with a PSG cap 43, the entire substrate surface is coated with a SiO₂ film 49 approximately 0.1 to 0.2 μm thick. Holes 49′ of size and shape corresponding to the size and shape of regions to be doped in the single-crystal silicon layer region corresponding to the region 22a in Fig. 2 are formed in respective positions in the SiO₂ film 49. Forming and patterning of the SiO₂ film 49 can be accomplished by conventional CVD and photolithographic processes. Then the PSG film (cap) 43 is coated as shown in Fig. 4(a).

When laser recrystallization effected through the PSG cap 43 and the SiO₂ mask 49, the recrystallized silicon 42a (corresponding to region 22 in Fig. 2) is doped as shown in Fig. 4(b). Fig. 4(b) shows a condition of the substrate after the PSG cap 43 and the SiO₂ film 49 have been removed. In Fig. 4(b) 49″ are phosphorus doped regions. Subsequent process steps are similar to those of Fig. 2(c) etc. The embodiment of Fig. 4 is applicable for fabricating, for example, a well region for complementary devices.

Second example

Embodiments of the present invention in accordance with the second example provide for the fabrication for example of a bipolar transistor in a recrystallized silicon region, utilizing a highly doped region fabricated by SOI technology as a buried layer.

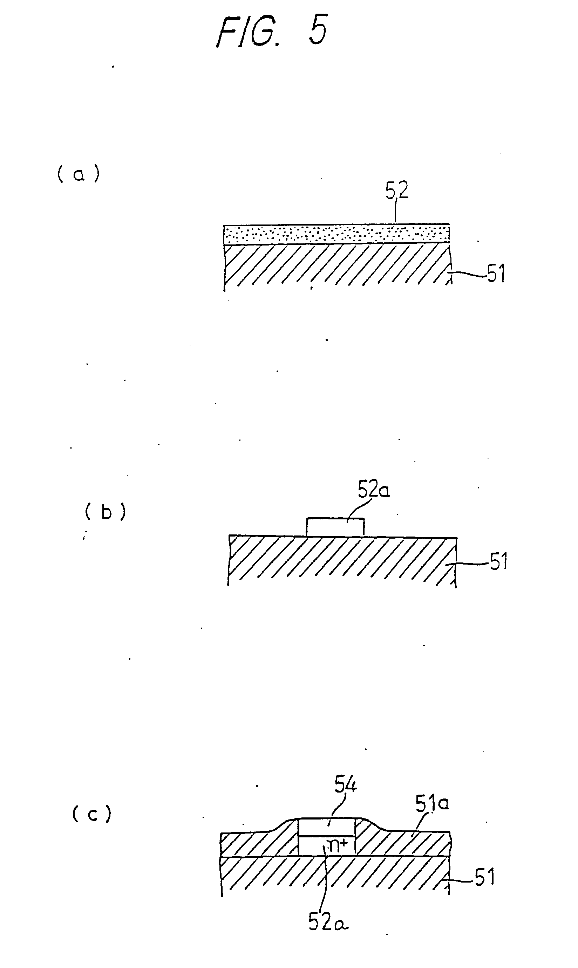

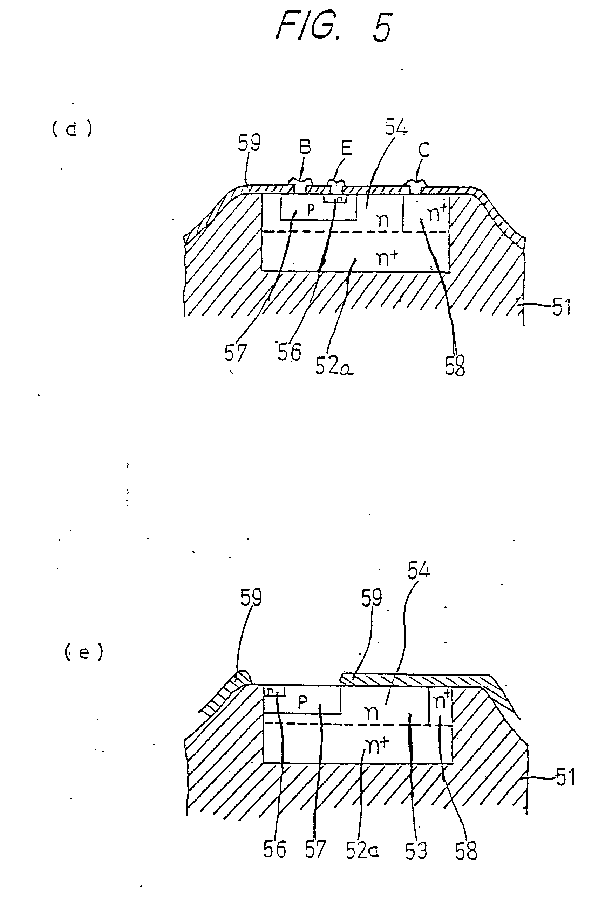

As shown in Fig. 5(a), over an insulating substrate 51 a poly-silicon layer 52 about 1 μm thick is grown and patterned to a predetermined form. Usually, the insulating substrate 51 is made of silicon dioxide (SiO₂) or sapphire, and the poly-silicon layer 52 is grown by chemical vapour deposition (CVD) and patterned by photo-lithography. Then the poly-silicon layer 52 is doped with antimony (Sb) by ion implantation with a dose of $1 \times 16^{16}/cm^2$ with a beam energy of 100 Kev. Next, the poly-silicon layer 52 is laser annealed with a YAG laser with an energy of 5 to 10 J/cm² and recrystallized to form a first single crystal layer 52a (Fig. 5(b)).

Various modifications are possible, for example the poly-silicon layer 52 may be coated over the substrate 51 and laser annealed first, then doped with n⁺-dopant and patterned, or the poly-silicon layer 52 may be patterned first, then doped and laser annealed. Patterning the poly-silicon first has an advantage, in that an entire pattern can be recrystallized by a single shot of a laser beam, since usually a pattern required for an ordinary circuit element or device such as a transistor or diode is so small that a pattern 52 (as seen in Fig. 5(a)) can be covered by a laser beam spot 30 to 40 μm in diameter, and the laser beam can be shifted from pattern to pattern observing the poly-crystal pattern 52. On the other hand, when recrystallization is effected before patterning, the laser spot cannot be positioned by aiming at a pattern (which will not be formed until after the recrystallization is finished) so it is necessary to pay attention to a requirement that a border of a recrystallized region should not be left in a recrystalled pattern 52a, since crystallization may not be perfect at the border of a recrystallised single crystal region 52a.

In the above, if the substrate 51 is a $SiO_2$ layer grown over a silicon substrate (not shown) it is possible to arrange the crystal axis orientation of the recrystallized single crystal region (52a) to coincide with that of the silicon substrate by exposing the silicon substrate surface at portions where the single crystal regions are to be grown. Such exposure of the silicon substrate can be effected by removing the $SiO_2$ layer 51 by photo-lithographic patterning.

On the first single crystal layer 52a, a second silicon single crystal layer 54 is grown by CVD or epitaxial growing method, and around the single crystal a second $SiO_2$ layer 51a is provided in a manner similar to that described with reference to Fig. 2, to obtain a substrate as shown in Fig. 5(c). The second single crystal region 54 is appropriately doped. The substrate of Fig. 5(c) is equivalent to that provided by the embodiment of Fig. 2 or that of Fig. 3.

As shown in Fig. 5(d), a bipolar transistor can be fabricated in the second silicon single crystal region 54. The second single crystal region 54 is utilized as a collector region, and the first single crystal region 52a is used as a buried layer. In Fig. 5(d), the single crystal regions are shown to an enlarged scale, and $SiO_2$ layers 51 and 51a are shown both together as a zone 51. 56, 57 and 58 are respectively an emitter region, a base region and a collector contact region. The collector contact region 58 contacts to the buried layer 52a, and a vertical transistor is formed. E, B and C are respectively an emitter electrode, a base electrode and a collector electrode, and 59 is a $SiO_2$ film used for surface protection.

A transistor as shown in Fig. 2(e) or in Fig. 5(d) has the advantages of high breakdown voltage and high operational speed as compared with an ordinary junction isolated transistor because the transistor of Fig. 2(e) or Fig. 5(d) is surrounded by insulator, and stray capacitance is very small.

Fabrication of a transistor as in Fig. 5(d) can be modified to make use of self alignment technologies, which are widely used in fabrication of fine pattern devices. Fig. 5(e) shows schematically an arrangement of electrodes fabricated by self alignment. In Fig. 5(e), unlike Fig. 5(d), the emitter region 56, base region 57 and collector contact region 58 are all aligned to a side edge of the second single crystal region 54. Considering the base pattern 57 for instance, the alignment of a mask 59 is not so critical; although the alignment of the mask may be slightly off-set as can be seen in Fig. 5(e), the left side of the base region 57 is aligned automatically (self aligned) by the edge of the single crystal region 54. Similarly the emitter region 56 and a collector region 58 are self aligned. By using such a configuration of electrode regions, mask alignment becomes very easy, or it is convenient for fabricating high speed devices which requires a precise mask alignment.

Third example

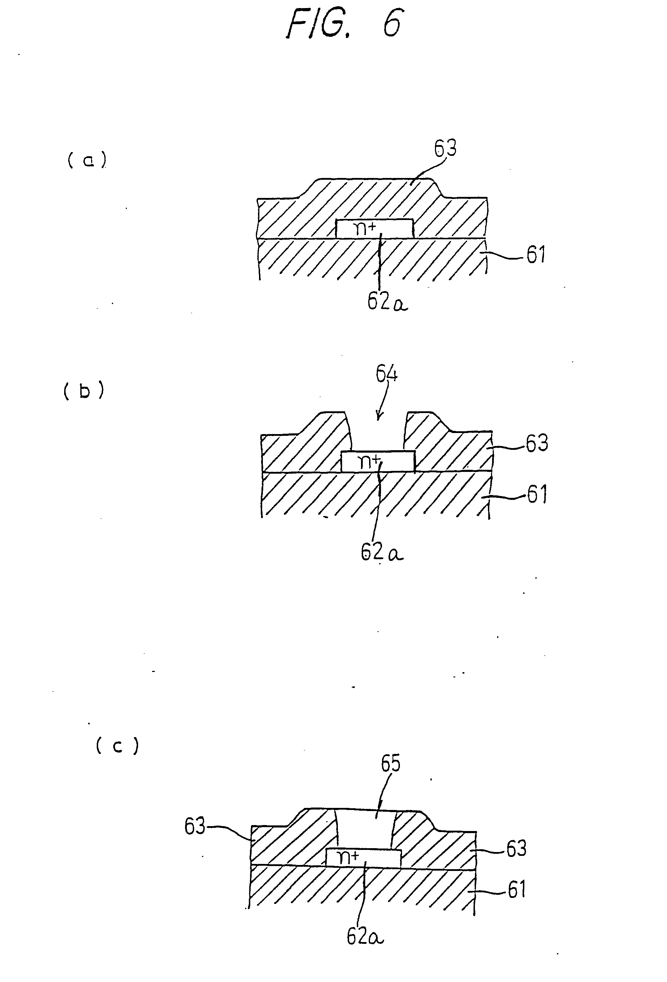

In this example an embodiment of the present invention provides a silicon single crystal region smaller than the (single crystal) buried layer on which it is formed, to avoid the effects of imperfect crystallisation at the border or boundary of a recrystallized single crystal zone. As shown in Fig. 6(a), on an insulator layer 61 (this insulator layer may be $SiO_2$ or sapphire) a single crystal doped buried layer 62a approximately 1 µm thick is formed covered by a cap 63 approximately 2 µm thick. The process used is similar to that of Fig. 2.

Next, a window 64 is opened over the cap 63, as shown in Fig. 6(b). The size of the window is smaller than that of the buried layer 62a, and it is positioned over the center part of the buried layer 62a leaving a sufficient margin to avoid the effects of crystal imperfection which occurs often at the border of a single crystal region (buried layer 62a).

Then, as shown in Fig. 6(c), in the window 64 is grown a second crystal layer region 65 by a selective epitaxial growing method which is similar to the method described with reference to Fig. 2. The substrate of Fig. 6(c) is equivalent to that of Fig. 5(c) or Fig. 2(d), and is ready for the fabrication of a transistor on the substrate. The substrate of Fig. 6(c) avoids the effect of crystal imperfection at the border of a single crystal region (buried layer 62a). Moreover, an advantage of this embodiment of the invention is that the cap 63 is left on the substrate, and it can be utilized later as a surface protection film of the entire device. So, the need for a step particularly for fabricating such a film is eliminated and manufacturing process is simplified.

Fourth example

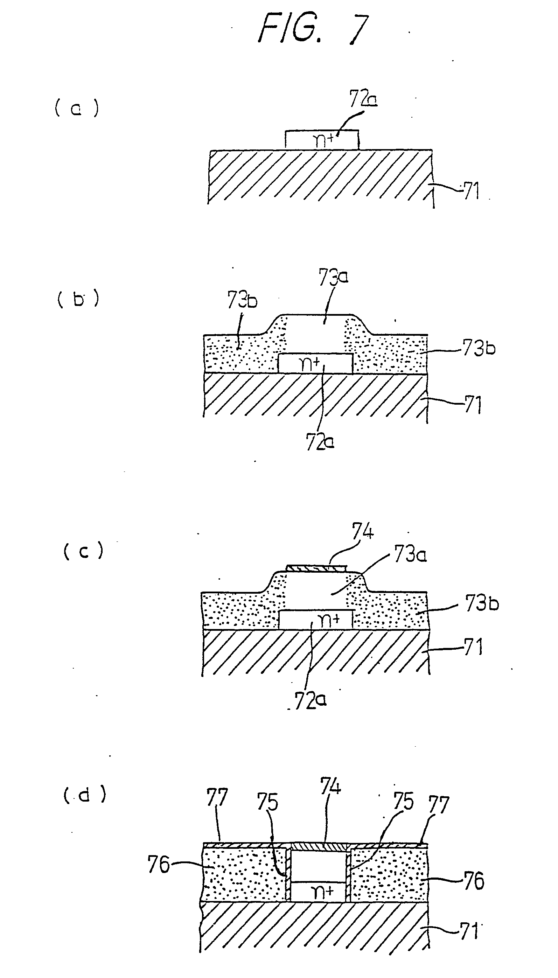

In this example embodiments of the present invention provide for the avoidance of undesirable effect of crystal imperfections at the peripheries of recrystallized single crystal regions. Fig. 7 gives cross sectional views of a substrate at various stages in a process embodying the present invention.

On a $SiO_2$ substrate 71 (the substrate may alternatively be of sapphire) approximately 1 µm thick a first silicon single crystal layer 72a is grown and patterned as shown in Fig. 7(a), using laser recrystallization. The first single crystal layer 72a is properly doped as appropriate to the device to be fabricated in it. The processes used are similar to those described with respect to Fig. 2 or Fig. 5. A highly doped buried layer (72a) is thus fabricated.

Next, a poly-silicon layer 2 µm thick is grown over the entire substrate surface (71 and 72a) by a CVD method. Then, by selective epitaxial growth a second single crystal layer 73a is grown over the first single crystal layer 72a, and over the remaining surface there is grown a poly-silicon layer 73b as shown in Fig. 7(b).

Next, the entire surface (73a, 73b) is coated with a silicon nitride film 74,200 nm (2,000 Å) thick and formed as shown in Fig. 7(c). The $Si_3N_4$ film is patterned just over the first single crystal layer 72a and its size is smaller than that of layer 72a. This patterning is intended to exclude imperfect crystal portions located at boundary areas of the recrystallized first single crystal layer 72a. Usually it is sufficient to pattern the $Si_3N_4$ film 74 approximately 0.5 to 1 μm inside (smaller) the border of the first single crystal layer 72a. This at the same time eases mask alignment tolerances.

Thereafter (Fig. 7(c) and Fig. 7(d)), the poly-silicon layer around the first and second single crystal layers 72a and 73a is etched off using a mixture of hydrofluoric acid and nitric acid in a volume ratio of 100:1 for example, using the $Si_3N_4$ film 74 as a mask, to expose the side wall of the single crystal regions 72a and 73a. The speeds with which poly-silicon and $SiO_2$ are etched are different, so the etching is easily controlled to leave the $SiO_2$ substrate unetched. By this etching, the exposed side walls of the single crystal regions are also etched, though the etching speed for poly-silicon is much greater than that for single crystal silicon, and crystal imperfections are rejected. The side walls are again oxidized and a $SiO_2$ film 75 approximately 400 nm (4,000 Å) thick is formed around the exposed side walls, by wet oxidation. Then, over the entire surface of the substrate, a poly-silicon layer 76 is grown again. The surface of the substrate is polished to show up the $Si_3N_4$ film 74. The surface of the poly-silicon layer 76 is oxidized again, and a new silicon dioxide film 77 about 1,000 Å thick is formed. The substrate is then as shown in Fig. 7(d).

Finally the $Si_3N_4$ film 74 is removed (the $Si_3N_4$ film is used as a surface protection film until the last stage), then the substrate of Fig. 7(d) is equivalent to that as used in Fig. 2(d), Fig. 5(d) or (e). Therefore, any kind of device element can be fabricated using the single crystal layers 73a and 72a. As mentioned above, the single crystal layer regions 73a and 72a are etched off at their boundary areas, so crystal imperfections are excluded perfectly. So, the substrate of Fig. 7(d) is especially applicable to fabrication of a self-aligned device, for example, as described with reference to Fig. 5(e).

As has been described above, an embodiment of the present invention provides a process for fabricating an SOI substrate which is capable of use for providing dielectric isolated ICs, especially for providing dielectric isolated bipolar devices. Some processes for fabricating device elements in a dielectric isolated region are simplified. A process is provided for forming a SOI substrate from which crystal imperfections are removed perfectly.

Particular embodiments of the present invention have been described by way of example only.

Other possibilities are encompassed by the invention. For example, the explanation above has been given with respect to $n^+$-type recrystallization and n-type doping, but it will be readily appreciated that p-type crystal regions can be provided. The technologies used in the described embodiments are conventional, so details of each technology such as etching, ion implantation, doping, chemical vapour deposition, oxidation, selective epitaxial growing and photo-lithographic patterning are omitted for the sake of simplicity. There may occur many modifications of the process by combination of such processes, but they are all in the scope of the present invention.

In the particularly described embodiments a laser beam is used for recrystallization, but in other embodiments other types of energy beam, such as an electron beam can be used.

## Claims

1. A process for fabricating a silicon on insulator (SOI) type semiconductor device, comprising processes of:

   (a) growing a poly-silicon layer on an insulating layer;

   (b) growing a cap layer on the poly-silicon layer, said cap layer containing impurity of one conductivity type; and

   (c) recrystallizing the poly-silicon layer to form a silicon single crystal layer by irradiation with an energy beam through the cap, and at the same time, doping the recrystallized silicon layer with the impurity contained in the cap layer.

2. A process according to claim 1, wherein

   the process (a) comprises a step of patterning the poly-silicon layer to a predetermined pattern; and

   the process (b) comprises a step of growing the cap layer over the insulating layer and the patterned poly-silicon layer.

3. A process according to claim 1 or 2, wherein the cap layer is of phospho-silicate glass or antimonic glass.

4. A process according to claim 1, 2 or 3, further comprising a process inserted before process (b), the inserted process comprising forming a mask having openings at predetermined positions, so that the recrystallized layer is subsequently doped selectively through the openings by the process (c).

5. A process according to claims 1, 2, 3 or 4, wherein the energy beam used in process (c) is a laser beam.

6. A process for fabricating a silicon on insulator (SOI) type semiconductor device, comprising processes of:

   (a) fabricating a first single crystal layer on an insulating layer, the first single crystal layer being patterned to an island-like shape, on the insulating layer, and having a first conductivity type;

   (b) depositing silicon on the insulating layer and the first single crystal layer, and growing a poly-silicon layer and second single crystal layer on the insulating layer and the first single crystal layer respectively;

(c) forming a further insulating layer around the borders of the first and second single crystal layers;

(d) forming a base region in the second single crystal layer, the base region having a conductivity type opposite to the first conductivity type; and

(e) forming an emitter region in the base region, the emitter region having the first conductivity type.

7. A process according to claim 6, further comprising, before the process (b), etching off the poly-silicon layer around the first and second single crystal layers.

8. A process for fabricating a silicon on insulator (SOI) type semiconductor device, comprising processes of:

(a) fabricating a first poly-silicon layer on an insulating layer, the first poly-silicon layer being patterned to an island-like shape, on the insulating layer, and having a first type conductivity;

(b) forming a cap layer composed from an insulating material over the insulating layer and the poly-silicon layer;

(c) recrystallizing the first poly-silicon layer by irradiation with an energy beam through the cap layer, and forming a first silicon single crystal layer;

(d) forming an opening window in the cap layer and exposing the first silicon single crystal layer through the window;

(e) forming a second silicon single crystal layer over the first single crystal layer in the window;

(f) forming a base region in the second single crystal layer; and

(g) forming an emitter region in the base region.

9. A process according to claim 8, wherein the energy beam is a laser beam.

10. A process according to claim 8 or 9, wherein the opening window has a smaller size than that of the first silicon single crystal layer beneath the window, and is positioned to a center portion of the first silicon single crystal layer.

11. A process according to any preceding claim, wherein the insulating (substrate) layer is a silicon dioxide layer.

12. A process according to any of claims 1 to 10, wherein the insulating (substrate) layer is of sapphire.

**Patentansprüche**

1. Verfahren zur Herstellung einer Halbleitervorrichtung vom Silicium-auf-Isolator-(SOI)-Typ mit den folgenden Prozessen:

(a) Aufwachsen einer Polysiliciumschicht auf einer isolierenden Schicht;

(b) Aufwachsen einer Kappenschicht auf der Polysiliciumschicht, welche genannte Kappenschicht eine Verunreinigung von einem Leitfähigkeitstyp enthält; und

(c) Rekristallisieren der Polysiliciumschicht, um eine Silicium-Einkristallschicht zu bilden, durch Bestrahlung mit einem Energiestrahl durch die Kappe und gleichzeitiges Dotieren der rekristallisierten Siliciumschicht mit der Verunreinigung, die in der Kappenschicht enthalten ist.

2. Verfahren nach Anspruch 1, bei dem der Prozeß (a) einen Schritt des Musterns der Polysiliciumschicht zu einem vorbestimmten Muster umfaßt; und

der Prozeß (b) einen Schritt des Aufwachsens der Kappenschicht über der isolierenden Schicht und der gemusterten Polysiliciumschicht umfaßt.

3. Verfahren nach Anspruch 1 oder 2, bei dem die Kappenschicht aus Phosphosilicatglas oder Antimonglas besteht.

4. Verfahren nach Anspruch 1, 2 oder 3, ferner mit einem Prozeß, der vor dem Prozeß (b) eingefügt wird, welcher eingefügte Prozeß das Bilden einer Maske umfaßt, die an vorbestimmten Positionen öffnungen aufweist, so daß die rekristallisierte Schicht danach durch den Prozeß (c) durch die öffnungen selektiv dotiert wird.

5. Verfahren nach Anspruch 1, 2, 3 oder 4, bei dem der bei dem Prozeß (c) verwendete Energiestrahl ein Laserstrahl ist.

6. Verfahren zur Herstellung einer Halbleitervorrichtung von Silicium-auf-Isolator-(SOI)-Typ, mit den folgenden Prozessen:

(a) Herstellen einer ersten einkristallinen Schicht auf einer isolierenden Schicht, welche erste einkristalline Schicht zu einer inselartigen Form auf der isolierenden Schicht gemustert wird und von einem ersten Leitfähigkeitstyp ist;

(b) Abscheiden von Silicium auf der isolierenden Schicht und der ersten einkristallinen Schicht und Aufwachsen einer Polysiliciumschicht und einer zweiten einkristallinen Schicht auf der isolierenden Schicht bzw. der ersten einkristallinen Schicht;

(c) Bilden einer weiteren isolierenden Schicht um die Ränder der ersten und zweiten einkristallinen Schichten;

(d) Bilden eines Basisbereiches in der zweiten einkristallinen Schicht, welcher Basisbereich einen Leitfähigkeitstyp entgegengesetzt zum ersten Leitfähigkeitstyp hat; und

(e) Bilden eines Emitterbereiches in dem Basisbereich, welcher Emitterbereich den ersten Leitfähigkeitstyp hat.

7. Verfahren nach Anspruch 6, ferner mit, vor dem Prozeß (b), Wegätzen der polykristallinen Schicht um die ersten und zweiten einkristallinen Schichten.

8. Verfahren zur Herstellung einer Halbleitervorrichtung vom Silicium-auf-Isolator-(SOI)-Typ, mit den folgenden Prozessen:

(a) Herstellung einer ersten polykristallinen Schicht auf einer isolierenden Schicht, wobei die Polysiliciumschicht zu einer inselartigen Form auf der isolierenden Schicht gemustert ist und einen ersten Leitfähigkeitstyp hat;

(b) Bilden einer Kappenschicht, die aus einem isolierenden Material zusammengesetzt ist, über der isolierenden Schicht und der Polysiliciumschicht;

(c) Rekristallisieren der ersten Polysiliciumschicht durch Bestrahlen mit einem Energiestrahl durch die Kappenschicht und Bilden einer ersten einkristallinen Schicht;

(d) Bilden eines öffnenden Fensters in der Kappenschicht und Exponieren der ersten einkristallinen Schicht durch das Fenster;

(e) Bilden einer zweiten einkristallinen Schicht über der ersten einkristallinen Schicht in dem Fenster;

(f) Bilden eines Basisbereiches in der zweiten einkristallinen Schicht; und

(g) Bilden eines Emitterbereiches in dem Basisbereich.

9. Verfahren nach Anspruch 8, bei dem der Energiestrahl ein Laserstrahl ist.

10. Verfahren nach Anspruch 8 oder 9, bei dem das öffnungsfenster eine kleinere Größe als die erste einkristalline Siliciumschicht unterhalb des Fensters hat und in einem zentralen Abschnitt der ersten einkristallinen Siliciumschicht positioniert ist.

11. Verfahren nach einem der vorhergehenden Ansprüche, bei dem die isolierende (Substrat)-Schicht eine Siliciumdioxidschicht ist.

12. Verfahren nach einem der Ansprüche 1 bis 10, bei dem die isolierende (Substrat)-Schicht aus Saphir besteht.

**Revendications**

1. Procédé de fabrication d'un dispositif à semi-conducteur du type "silicium sur isolant" (SOI), comprenant les opérations suivantes:

(a) faire croître une couche de silicium polycristallin sur une couche isolante;

(b) faire croître une couche de capuchon sur la couche de silicium polycristallin, ladite couche de capuchon contenant une impureté d'un premier type de conductivité; et

(c) faire recristalliser la couche de silicium polycristallin afin de former une couche monocristalline de silicium par irradiation à l'aide d'un faisceau d'énergie au travers du capuchon et, en même temps, doper la couche de silicium recristallisée à l'aide de l'impureté contenue dans la couche de capuchon.

2. Procédé selon la revendication 1, où:

l'opération (a) comprend l'opération consistant à configurer la couche de silicium polycristallin suivant un motif prédéterminé; et

l'opération (b) comprend l'opération consistant à faire croître la couche de capuchon sur la couche isolante et la couche de silicium polycristallin configurée.

3. Procédé selon la revendication 1 ou 2, où la couche de capuchon est faite de verre de phospho-silicate ou de verre d'antimoine.

4. Procédé selon la revendication 1, 2 ou 3, comprenant en outre une opération, qui s'insère avant l'opération (b), ladite opération insérée consistant à former un masque qui possède des ouvertures en des positions prédéterminées, si bien que la couche recristallisée est ultérieurement dopée de manière sélective au travers des ouvertures par l'opération (c).

5. Procédé selon la revendication 1, 2, 3 ou 4, où le faisceau d'énergie utilisé dans l'opération (c) est un faisceau laser.

6. Procédé de fabrication d'un dispositif à semiconducteur du type "silicium sur isolant" (SOI), comprenant les opérations suivantes:

(a) fabriquer une première couche monocristalline sur une couche isolante, la première couche monocristalline étant configurée sui-vant une forme d'îlot sur la couche isolante et ayant un premier type de conductivité;

(b) déposer du silicium sur la couche isolante et la première couche monocristalline et faire croître une couche de silicium polycristallin et une deuxième couche monocristalline respectivement sur la couche isolante et la première couche monocristalline;

(c) former une autre couche isolante autour des bords des première et deuxième couches monocristallines;

(d) former une région de base dans la deuxième couche monocristalline, la région de base ayant un type de conductivité opposé au premier type de conductivité; et

(e) former une région d'émetteur dans la région de base, la région d'émetteur ayant le premier type de conductivité.

7. Procédé selon la revendication 6, comprenant en outre, avant l'opération (b), l'opération consistant à enlever par gravure la couche de silicium polycristallin autour des première et deuxième couches monocristallines.

8. Procédé de fabrication d'un dispositif à semiconducteur du type "silicium sur isolant" (SOI), comprenant les opérations suivantes:

(a) fabriquer une première couche de silicium polycristallin sur une couche isolante, la première couche de silicium polycristallin étant configurée suivant une forme d'îlot sur la couche isolante et possédant un premier type de conductivité;

(b) former une couche de capuchon constitu-tée d'un matériau isolant sur la couche isolante et la couche de silicium polycristallin;

(c) faire recristalliser la première couche de silicium polycristallin par irradiation à l'aide d'un faisceau d'énergie au travers de la couche de capuchon et former une première couche monocristalline de silicium;

(d) former une fenêtre d'ouverture dans la couche de capuchon et exposer la première couche monocristalline de silicium au travers de la fenêtre;

(e) former une deuxième couche monocristalline de silicium sur la première couche monocristalline dans la fenêtre;

(f) former une région de base dans la deuxième couche monocristalline; et

(g) former une région d'émetteur dans la région de base.

9. Procédé selon la revendication 8, où le faisceau d'énergie est un faisceau laser.

10. Procédé selon la revendication 8 ou 9, où la fenêtre d'ouverture possède une taille plus petite que celle de la première couche monocristalline de silicium se trouvant au-dessous de la fenêtre, et est placée en une position centrale de la première couche monocristalline de silicium.

11. Procédé selon l'une quelconque des revendications précédentes, où la couche (substrat) isolante est une couche de dioxyde de silicium.

12. Procédé selon l'une quelconque des revendications 1 à 10, où la couche (substrat) isolante est faite de saphir.

# FIG. 1

(a)

(b)

(c)

(d)

(e)

# FIG. 2

( a )

22    23

21

( b )

22a

n+

21

(.c )

24a

24b    24b

n+

21

22a

( d )

24a

25    25

n+

21

22a

( e )

B    E    29    C    28

25    25

n+    24a

27    26

22a

# FIG. 3

( a )

32    33

31

31a

( b )

32a

n+

31

( c )

34a

34b

n+

31

32a

# FIG. 4

(a)

(b)

# FIG. 5

( a )

52

51

( b )

52a

51

( c )

54

51a

n+

52a

51

# FIG. 5

(d)

(e)

# FIG. 6

( a )

63

n+

61

62a

( b )

64

63

n+

61

62a

( c )

65

63

63

n+

61

62a

# FIG. 7

( a )

72a

n+

71

( b )

73b

73a

73b

n+

71

72a

( c )

74

73a

73b

n+

71

72a

( d )

77   75   74   75   77

76

n+

76

71